# EUROPÄISCHE PATENTSCHRIFT

(11) **EP 0 552 475 B1**
(45) Veröffentlichungstag und Bekanntmachung des Hinweises auf die Patenterteilung: **10.09.1997**
(21) Anmeldenummer: 92121602.4
(22) Anmeldetag: 18.12.1992
(51) Int. Cl.: H01L 23/373, H01L 23/492

(54) **Halbleitermodul mit hoher Isolations- und Wärmefähigkeit**
Semiconductor module with high insulating and heat dissipating capability
Module semiconducteur comprenant des capacités isolantes et thermodissipatrices hautes

(30) Priorität: 23.01.1992 DE 4201794
(43) Veröffentlichungstag der Anmeldung: 28.07.1993
(73) Patentinhaber: SIEMENS AKTIENGESELLSCHAFT, 80333 München (DE)
(72) Erfinder: Wolfgang, Eckhard, Dr., W-8000 München 70 (DE); Kuhnert, Reinhold, Dr., W-8000 München 19 (DE)

(56) Entgegenhaltungen:
- EP-A- 0 142 282
- EP-A- 0 221 531
- EP-A- 0 284 150
- EP-A- 0 327 336
- FR-A- 2 545 987
- GB-A- 2 112 569
- US-A- 5 031 029
- IBM TECHNICAL DISCLOSURE BULLETIN Bd. 31, Nr. 11, April 1989, NEW YORK Seiten 355 - 357 'thermally conducting and electrically insulating chemical coating'

## Beschreibung

Die Erfindung betrifft ein Halbleitermodul nach den gleichlautenden Oberbegriffen der Patentansprüche 1 und 10.

Halbleitermodule der gattungsgemäßen Art, die zwischen einem Halbleiterchip und einer Wärmeableiteinrichtung eine elektrisch isolierende und wärmeleitende Schicht aufweisen sind beispielsweise bereits aus den Unterlagen zum 5. Kolloqium "Verbindungstechnik in der Elektronik", Fellbach, 20. bis 22.02.1990, Seite 25 bis 29, bekannt. Dabei handelt es sich beispielsweise bei der isolierenden Schicht um eine Al₂O₃-Schicht auf die beidseitig Zwischenschichten aus Kupfer aufgebracht sind (direct copper bonding). Der Halbleiterchip ist über eine Lotschicht mit der einen Zwischenschicht und die Wärmeableiteinrichtung ist über eine weitere Lotschicht oder eine Kleberschicht mit der anderen Zwischenschicht verbunden.

Der Erfindung liegt die Aufgabe zugrunde, ein Halbleitermodul anzugeben, das bei einer vergleichbaren Isolationsfähigkeit zwischen dem Halbleiterchip und der Wärmeableiteinrichtung einen wesentlich geringeren Wärmewiderstand zwischen dem Halbleiterchip und der Wärmeableiteinrichtung besitzt als die bekannten Halbleitermodule. Die Aufgabe wird erfindungsgemäß durch die im jeweiligen kennzeichnenden Teil der Patentansprüche 1 und 10 angegebenen Merkmale gelöst.

Die Ansprüche 2 bis 9 sind auf bevorzugte Ausbildungen des erfindungsgemäßen Halbleitermoduls gerichtet.

Die Erfindung wird nachfolgend anhand der Zeichnung näher erläutert. Dabei zeigt
- Figur 1: eine Querschnittsdarstellung eines bekannten Halbleitermoduls,
- Figur 2: eine Querschnittsdarstellung eines erfindungsgemäßen Halbleitermoduls, wobei die Bodenplatte des halbleiterbauelements als Wärmeableiteinrichtung dient,
- Figur 3: eine Querschnittsdarstellung eines erfindungsgemäßen Halbleitermoduls, wobei die Wärmeableiteinrichtung aus einem Kühlkörper besteht und
- Figur 4: eine Querschnittsdarstellung eines erfindungsgemäßen Halbleitermoduls nach Figur 3, bei dem die isolierende Schicht direkt auf den Kühlkörper aufgebracht ist.

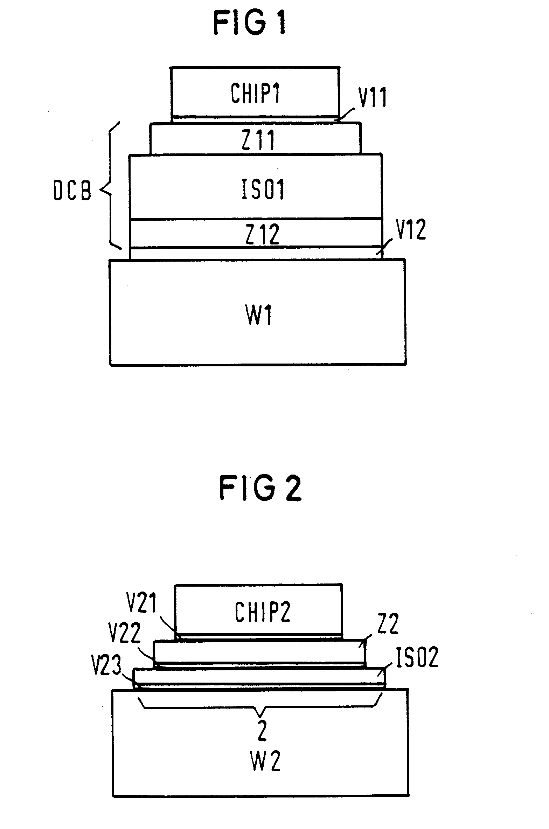

Figur 1 zeigt eine Querschnittsdarstellung eines bekannten Halbleitermoduls, bei dem sich zwischen einem Halbleiterchip CHIP1 und einer Wärmeableiteinrichtung W1 ein DCB-Substrat DCB (direct copper bonding) befindet, das aus einer Isolatorschicht ISO1 mit beidseitig aufgebrachten Zwischenschichten Z11 und Z12 aus Kupfer besteht. Die Wärmeableiteinrichtung W1 wird aus einer Bodenplatte des Halbleitermoduls gebildet, die beispielsweise aus einem 3 mm starken Kupferblech besteht. Der Halbleiterchip CHIP1 ist dabei über eine Verbindungsschicht V11 in Form einer Lotschicht mit einer Zwischenschicht Z12 und diese wiederum über eine Verbindungsschicht V12 in Form einer Lotschicht oder Kleberschicht mit der Wärmeableiteinrichtung W1 mechanisch verbunden. Geht man typischerweise von einer Lotschicht V11 mit einer Dicke von 50 µm und einer Lotschicht bzw. Kleberschicht V12 mit einer Dicke von ca. 100 µm, Zwischenschichten Z11 und Z22 mit einer jeweiligen Dicke von 300 µm und einer isolierenden Schicht ISO1 aus üblichen Keramiken wie Al₂O₃ bzw. AlN mit einer Schichtdicke von ca. 600 µm aus, so ergibt sich bei einer Wärmeleitfähigkeit von Kupfer k = 3,8 W/cm K und einer Wärmeleitfähigkeit von k = 0,3 W/cm K für Al₂O₃ zusammen mit dem Wärmewiderstand der Bodenplatte ein eindimensionaler Wärmewiderstand von Rₜₕ = ca. 0,35 K cm²/W. Aufgrund der zur Wärmeableiteinrichtung hin größer werdenden lateralen Abmessungen ergibt sich zusätzlich eine Wärmespreizung die einer Senkung des effektiv wirksamen Wärmewiderstands gleichkommt.

Ein wesentlicher Grundgedanke der Erfindung ist die gleichzeitige Optimierung des Wärmewiderstands der isolierenden Schicht und des Wärmewiderstands der Verbindungsschichten. Eine erste Ausführungsform eines erfindungsgemäßen Halbleitermoduls ist in Figur 2 dargestellt und weist zwischen einem Halbleiterchip CHIP2 und einer Wärmeableiteinrichtung W2 in Form einer Bodenplatte eine Zwischenschicht Z2 und eine isolierende Schicht ISO2 aus kristallinem Kohlenstoff (Diamant) auf. Unter Schichten aus kristallinem Kohlenstoff sind hierbei polykristalline aber auch monokristalline Kohlenstoffschichten zu verstehen, wobei letztere beispielsweise durch gezieltes Setzen von Kristallisationskeimen erzeugbar sind und aufgrund der fehlenden Korngrenzen eine bessere Wärmeleitfähigkeit als polykristalline Kohlenstoffschichten aufweisen. Zwischen dem Halbleiterchip CHIP2 und der Zwischenschicht Z2, die beispielsweise aus Kupfer besteht und bei vertikalen Bauelementen zur Kontaktierung dient, befindet sich erfindungsgemäß eine Verbindungsschicht V21 aus Silber. Die Zwischenschicht Z2 ist ebenfalls durch eine Silberschicht V22 mit der Isolatorschicht ISO2 und die Isolatorschicht ISO2 ihrerseits ist wiederum über eine Verbindungsschicht V23 mit einem Stirnflächenbereich 2 der leiteinrichtung W2 mechanisch verbunden. Zur Herstellung des erfindungsgemäßen Halbleitermoduls wird beispielsweise auf die Zwischenschicht Z2 im Bereich der Kontaktierungsflächen und bei der Wärmeableiteinrichtung W2 im Stirnflächenbereich 2 eine Silberpaste, beispielsweise durch Siebdruck aufgebracht und anschließend mit Hilfe eines als Drucksintern bezeichneten Verfahrens der Niedertemperaturverbindungstechnik, das für sich bereits bekannt ist, eine mechanische Verbindung zwischen dem Halbleiterchip CHIP2 und der Wärmeableiteinrichtung W2 bewirkt. Die Schichtdicke der Silberpaste beträgt dabei etwa 10 bis 100 µm und besteht aus Silberpulver mit plättchenförmigen Pulverpartikeln die in Cyclohexanol als Lösungsmittel suspendiert sind. Die Sintertemperatur beträgt zum Beispiel 230°C und während einer Sinterzeit von etwa 1 Minute wird ein Druck von mindestens 900 N/cm² auf die gesamte Anordnung in vertikaler Richtung ausgeübt. Die Sintertemperatur kann in einem Bereich liegen der einen unteren Grenzwert von etwa 150°C und einen oberen Grenzwert von etwa 250°C aufweist. Es ist darauf hinzuweisen, daß bereits bei Sinterzeiten von einigen Sekunden eine ausreichende Verbindung der genannten Teile erreicht wird und daß der Druck auch auf 1 bis 2 t/cm² gesteigert werden kann. Um beim Halbleiterchip CHIP2 und bei der Zwischenschicht Z2 sinterfähige Oberflächen zu schaffen, wird beispielsweise eine Schichtenfolge von Titan, Platin und Gold aufgedampft oder gesputtert und der Stirnflächenbereich 2 der Wärmeableiteinrichtung beispielsweise erst vernickelt und dann versilbert oder, wie bei der Zwischenschicht, mit einer Schichtenfolge aus Titan, Platin und Gold versehen. Werden beispielsweise die Dicken der Verbindungsschichten V21 ... V23 jeweils 10 µm, die Dicke der Zwischenschicht Z2 mit 300 µm, die Dicke der kristallinen Kohlenstoffschicht ISO2 gleich 100 µm und die Dicke der Bodenplatte, wie bei Figur 1, mit 3 mm gewählt, so ergibt sich bei einer Wärmeleitfähigkeit von beispielsweise polykristallinem Kohlenstoff (Diamant) k = 12 W/cm K und den Verbindungsschichten aus Silber mit k = 4 W/cm K zusammen mit dem Wärmewiderstand der Bodenplatte ein eindimensionaler Wärmewiderstand Rₜₕ von ca. 0,1 K cm²/W. Bei vergleichbarer Isolationsfähigkeit wird hierbei ein ca. um den Faktor 3 geringerer meübergangswiderstand erreicht.

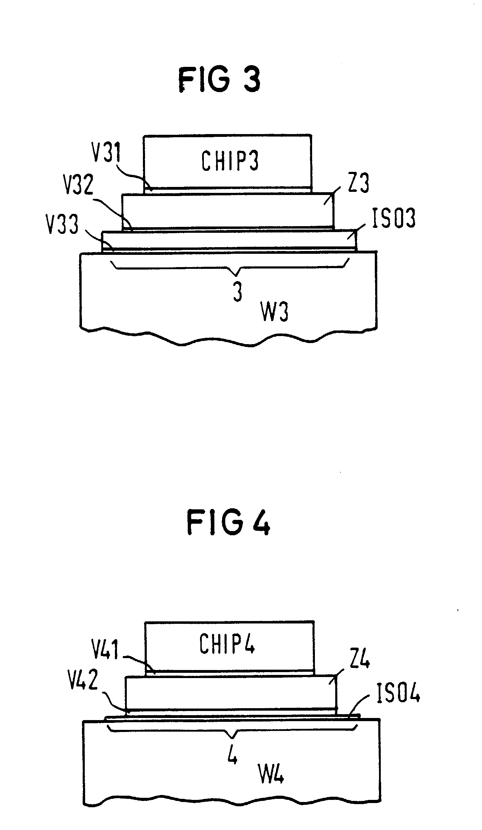

Eine zweite, in Figur 3 dargestellte, Ausführungsform des erfindungsgemäßen Halbleitermoduls besteht aus einem Halbleiterchip CHIP3, Verbindungsschichten V31 ... V33, einer Zwischenschicht Z3 und einer Isolatorschicht ISO3 aus kristallinem Kohlenstoff und einer Wärmeableiteinrichtung W3, wobei der Aufbau des Halbleitermoduls nach Figur 2 mit dem Aufbau des Halbleitermoduls nach Figur 3 bis auf die Wärmeableiteinrichtung W3 identisch ist. Anstelle der Wärmeableiteinrichtung W2 in Form einer Bodenplatte, besteht die Wärmeableiteinrichtung W3 aus einem Kühlkörper der beispielsweise aus Aluminium oder Kupfer besteht und bei dem ein Stirnflächenbereich 3 eine sinterfähige Oberfläche besitzt. Mit dem oben beispielhaft angegebenen Schichtdicken ist hierbei, bei eindimensionaler Betrachtungsweise, ein thermischer Widerstand Rₜₕ = ungefähr 0,02 K/W cm² zwischen dem Halbleiterchip (CHIP3) und einem Stirnflächenbereich 3 des Kühlkörpers erreichbar.

In Figur 4 ist ein drittes Ausführungsbeispiel des erfindungsgemäßen Halbleitermoduls gezeigt, bei dem sich zwischen einem Halbleiterchip CHIP4 und einer Wärmeableiteinrichtung W4 in Form eines Kühlkörpers, Verbindungsschichten V41 und V42, eine Zwischenschicht Z4 und eine isolierende Schicht ISO4 aus kristallinem Kohlenstoff befinden, wobei die Isolatorschicht ISO4 auf einem Stirnflächenbereich 4 des Kühlkörpers aufgewachsen ist und wobei die Verbindungsschicht V42 die isolierende Schicht mit der Zwischenschicht Z4 und die Verbindungsschicht V41 den Halbleiterchip CHIP4 mit der Zwischenschicht Z4 verbindet. Die in Figur 4 dargestellte Ausführungsform unterscheidet sich von der in Figur 3 gezeigten Ausführungsform lediglich dadurch, daß die Isolatorschicht ISO4 direkt auf dem Kühlkörper W4 aufgewachsen ist und keine Verbindungsschicht zwischen der isolierenden Schicht und der Wärmeableiteinrichtung vorgesehen ist. Durch die Einsparung einer Verbindungsschicht und die Möglichkeit einer dünneren isolierenden Schicht, beispielsweise einer polykristallinen Kohlenstoffschicht mit einer Dicke von 30 µm, die aufgrund der direkten Aufwachsung auf dem Kühlkörper besser handhabbar ist, ist eine weitere Senkung des Wärmewiderstands möglich. Vor dem Aufwachsen der Isolatorschicht im Stirnflächenbereich 4 des Kühlkörpers kann dieser Bereich mit einer Schicht aus beispielsweise Molybdän oder Aluminium versehen werden. Der Wärmeübergangswiderstand Rₜₕ zwischen dem Halbleiterchip CHIP4 und dem Stirnflächenbereich 4 des Kühlkörpers beträgt ca. 0,01 K/W cm², sofern die Schichtdicken wie bei Figur 2 gewählt werden. Für Anwendungen, bei denen nur Spannungen unterhalb 100 V auftreten, können neben kristallinen auch amorphe Kohlenstoffschichten, sogenannte a-C:H-Schichten, mit einer Dicke von weniger als ca. 1 µm Verwendung finden, diese weisen jedoch eine geringere Isolationsfähigkeit und eine niedrigere Wärmeleitfähigkeit auf als kristalline Kohlenstoffschichten.

Die erfindungsgemäßen Halbleitermodule betreffen den Bereich der Leistungshalbleiter, wie beispielsweise Thyristoren, andere Halbleiterbauelemente bei denen hohe Verlustleistungen auftreten, wie zum Beispiel Laser- oder Hochleistungsleuchtdioden sowie Mikrowellenbauelemente aber auch IC's, bei denen eine gute Wärmeabfuhr von Nöten ist. Auf die Zwischenschicht aus Kupfer, die zur Kontaktierung dient, kann gegebenenfalls verzichtet werden.

## Patentansprüche

1. Halbleitermodul, bei dem zwischen einem Halbleiterchip (CHIP1 ... CHIP4) und einer Wärmeableiteinrichtung (W1 ... W4) eine elektrisch isolierende und wärmeleitende Schicht (ISO1 ... ISO4) vorgesehen ist und bei dem eine mechanische Verbindung zwischen dem Halbleiterchip, der isolierenden Schicht und der Wärmeableiteinrichtung über Verbindungsschichten (V11 ... V42) und mindestens einer Zwischenschicht (Z2 ... Z12) besteht, **dadurch gekennzeichnet**, daß die elektrisch isolierende und wärmeleitende Schicht (ISO2 ... ISO4) aus kristallinem Kohlenstoff und die Verbindungsschichten aus Silber bestehen.

2. Halbleitermodul nach Anspruch 1, **dadurch gekennzeichnet,** daß zwischen dem Halbleiterchip (CHIP2 ... CHIP4) und der isolierenden Schicht (ISO2 ... ISO4) nur eine Zwischenschicht (Z2 ... Z4) vorgesehen ist und die Zwischenschicht sowohl mit dem Halbleiterchip als auch mit der isolierenden Schicht jeweils über eine der Verbindungsschichten (V21 ... V42) mechanisch verbunden ist.

3. Halbleitermodul nach Anspruch 1 oder 2, **dadurch gekennzeichnet,** daß die mechanische Verbindung des Halbleiterchips (CHIP2 ... CHIP4), der Zwischenschicht (Z2 ... Z4) der isolierenden Schicht (ISO2 ... ISO4) und der Wärmeableiteinrichtung (W2 ... W4) durch Drucksintern erzeugbar ist.

4. Halbleitermodul nach einem der Ansprüche 1 bis 3, **dadurch gekennzeichnet,** daß die Zwischenschicht aus Kupfer besteht, die der Reihe nach einen Überzug aus Nickel und einen Überzug aus Silber oder der Reihe nach jeweils einen Überzug aus Titan, Platin und Gold besitzt.

5. Halbleitermodul nach einem der Ansprüche 1 bis 4, **dadurch gekennzeichnet**, daß die Wärmeableiteinrichtung (W2) aus einer metallischen Bodenplatte des Halbleitermoduls besteht und die Bodenplatte einen sinterfähigen Stirnflächenbereich (2) besitzt.

6. Halbleitermodul nach einem der Ansprüche 1 bis 4, **dadurch gekennzeichnet,** daß die Wärmeableiteinrichtung (W3) aus einem Kühlkörper besteht und der Kühlkörper einen sinterfähigen Stirnflächenbereich (3) besitzt.

7. Halbleitermodul nach einem der Ansprüche 1 bis 4, **dadurch gekennzeichnet,** daß die Wärmeableiteinrichtung (W4) aus einem Kühlkörper besteht und daß direkt auf einem Stirnflächenbereich(4) des Kühlkörpers die isolierende Schicht (ISO4) aus kristallinem Kohlenstoff abgeschieden ist.

8. Halbleitermodul nach einem der Ansprüche 1 bis 7, **dadurch gekennzeichnet,** daß die elektrisch isolierende und wärmeleitende Schicht (ISO2 ... ISO4) aus polykristallinem Kohlenstoff besteht.

9. Halbleitermodul nach einem der Ansprüche 1 bis 7, **dadurch gekennzeichnet**, daß die elektrisch isolierende und wärmeleitende Schicht (ISO2 ... ISO4) aus monokristallinem Kohlenstoff besteht.

10. Halbleitermodul, bei dem zwischen einem Halbleiterchip (CHIP ... CHIP4) und einer Wärmeableiteinrichtung (W1 ... W4) eine elektrisch isolierende und wärmeleitende Schicht (ISO1 ... ISO4) vorgesehen ist und bei dem eine mechanische Verbindung zwischen dem Halbleiterchip, der isolierenden Schicht und der Wärmeableiteinrichtung über Verbindungsschichten (V11 ... V42) und mindestens einer Zwischenschicht (Z2 ... Z12) besteht, **dadurch gekennzeichnet,** daß die elektrisch isolierende und wärmeleitende Schicht (ISO2 ... ISO4) aus amorphem Kohlenstoff und die Verbindungsschichten aus Silber bestehen.

## Claims

1. Semiconductor module, in which an electrically insulating and heat-conducting layer (ISO1 ... ISO4) is provided between a semiconductor chip (CHIP1 ... CHIP4) and a heat-dissipating device (W1 ... W4), and in which there is a mechanical connection between the semiconductor chip, the insulating layer and the heat-dissipating device by means of bonding layers (V11 ... V42) and at least one intermediate layer (Z2 ... Z12), characterized in that the electrically insulating and heat-conducting layer (ISO2 ... ISO4) consists of crystalline carbon and the bonding layers consist of silver.

2. Semiconductor module according to Claim 1, characterized in that only one intermediate layer (Z2 ... Z4) is provided between the semiconductor chip (CHIP2 ... CHIP4) and the insulating layer (ISO2 ... ISO4), and the intermediate layer is mechanically connected both to the semiconductor chip and to the insulating layer by means of one of the bonding layers (V21 ... V42) in each case.

3. Semiconductor module according to Claim 1 or 2, characterized in that the mechanical connection of the semiconductor chip (CHIP2 ... CHIP4), of the intermediate layer (Z2 ... Z4), of the insulating layer (ISO2 ... ISO4) and of the heat-dissipating device (W2 ... W4) can be produced by pressure sintering.

4. Semiconductor module according to one of Claims 1 to 3, characterized in that the intermediate layer consists of copper which has, in order, a coating of nickel and a coating of silver or, in order, a respective coating of titanium, platinum and gold.

5. Semiconductor module according to one of Claims 1 to 4, characterized in that the heat-dissipating device (W2) comprises a metallic baseplate of the semiconductor module and the baseplate has a sinterable end-face region (2).

6. Semiconductor module according to one of Claims 1 to 4, characterized in that the heat-dissipating device (W3) comprises a heat sink and the heat sink has a sinterable end-face region (3).

7. Semiconductor module according to one of Claims 1 to 4, characterized in that the heat-dissipating device (W4) comprises a heat sink, and in that the insulating layer (ISO4) made of crystalline carbon is deposited directly on an end-face region (4) of the heat sink.

8. Semiconductor module according to one of Claims 1 to 7, characterized in that the electrically insulating and heat-conducting layer (IsO2 ... ISO4) consists of polycrystalline carbon.

9. Semiconductor module according to one of Claims 1 to 7, characterized in that the electrically insulating and heat-conducting layer (ISO2 ... ISO4) consists of monocrystalline carbon.

10. Semiconductor module, in which an electrically insulating and heat-conducting layer (ISO1 ... ISO4) is provided between a semiconductor chip (CHIP1 ... CHIP4) and a heat-dissipating device (W1 ... W4), and in which there is a mechanical connection between the semiconductor chip, the insulating layer and the heat-dissipating device by means of bonding layers (V11 ... V42) and at least one intermediate layer (Z2 ... Z12), characterized in that the electrically insulating and heat-conducting layer (ISO2 ... ISO4) consists of amorphous carbon and the bonding layers consist of silver.

## Revendications

1. Module semi-conducteur, dans lequel est prévue une couche électriquement isolante et thermoconductrice (ISO1... ISO4) entre une puce de semi-conducteur (CHIP1 ... CHIP4) et un dispositif thermodissipateur (W1 ... W4) et dans lequel existe une liaison mécanique entre la puce de semi-conducteur, la couche isolante et le dispositif thermodissipateur au moyen de couches de liaison (V11 ... V42) et d'au moins une couche intermédiaire (Z2 ... Z12), caractérisé en ce que la couche électriquement isolante et thermoconductrice (ISO2 ... ISO4) est composée de carbone cristallin et les couches de liaison d'argent.

2. Module semi-conducteur selon la revendication 1, caractérisé en ce qu'entre la puce de semi-conducteur (CHIP2 ... CHIP4) et la couche isolante (ISO2 .. ISO4) n'est prévue qu'une couche intermédiaire (Z2 ... Z4) et la couche intermédiaire est reliée mécaniquement non seulement à la puce de semi-conducteur mais encore à la couche isolante à chaque fois par l'une des couches de liaison (V21 ... V42).

3. Module semi-conducteur selon la revendication 1 ou 2, caractérisé en ce que la liaison mécanique de la puce de semi-conducteur (CHIP2 ... CHIP4), de la couche intermédiaire (Z2 ... Z4) de la couche isolante (ISO2 ... ISO4) et du dispositif thermodissipateur (W2 ... W4) peut être créée par frittage sous pression.

4. Module semi-conducteur selon l'une des revendications 1 à 3, caractérisé en ce que la couche intermédiaire est composée de cuivre et possède dans l'ordre une pellicule de nickel et une pellicule d'argent ou dans l'ordre respectivement une pellicule de titane, platine et or.

5. Module semi-conducteur selon l'une des revendications 1 à 4, caractérisé en ce que le dispositif thermodissipateur (W2) est composé d'une plaque de base métallique du module semi-conducteur et la plaque de base possède une zone de surface avant (2) apte au frittage.

6. Module semi-conducteur selon l'une des revendications 1 à 4, caractérisé en ce que le dispositif thermodissipateur (W3) est composé d'un refroidisseur et ce refroidisseur possède une zone de surface avant (3) apte au frittage.

7. Module semi-conducteur selon l'une des revendications 1 à 4, caractérisé en ce que le dispositif thermodissipateur (W4) est composé d'un refroidisseur et en ce que la couche isolante (ISO4) en carbone cristallin est déposée directement sur une zone de surface avant (4) du refroidisseur.

8. Module semi-conducteur selon l'une des revendications 1 à 7, caractérisé en ce que la couche électriquement isolante et thermoconductrice (ISO2 ... ISO4) est composée de carbone polycristallin.

9. Module semi-conducteur selon l'une des revendications 1 à 7, caractérisé en ce que la couche électriquement isolante et thermoconductrice (ISO2 ... ISO4) est composée de carbone monocristallin.

10. Module semi-conducteur, dans lequel une couche électriquement isolante et thermoconductrice (ISO1 ... ISO4) est prévue entre une puce de semi-conducteur (CHIP ... CHIP4) et un dispositif thermodissipateur (W1 ... W4) et dans lequel existe une liaison mécanique entre la puce de semi-conducteur, la couche isolante et le dispositif thermodissipateur au moyen de couches de liaison (V11 ... V42) et d'au moins une couche intermédiaire (Z2 ... Z12), caractérisé en ce que la couche électriquement isolante et thermoconductrice (ISO2 ... ISO4) est composée de carbone amorphe et les couches de liaison d'argent.
